# EUROPEAN PATENT APPLICATION

(11) **EP 4 819 361 A1**
(43) Date of publication of application: **07.10.2026**
(21) Application number: 25909613.9
(22) Date of filing: 19.11.2025
(51) Int. Cl.: H01M 50/531, H01M 50/514, H01M 50/519

(54) **BATTERY PACK AND ELECTRICAL DEVICE**

(30) Priority: 30.12.2024 CN 202423303230 U
(71) Applicant: Sunwoda Mobility Energy Technology Co., Ltd., Shenzhen, Guangdong 518107 (CN)
(72) Inventor: SUN, Lingxiao, Shenzhen, Guangdong 518107 (CN)
(74) Representative: Elzaburu S.L.P.
(86) International application number: PCT/CN2025/136188
(87) International publication number: WO 2026/144620

(57) **Abstract**

The present application discloses a battery pack and an electrical apparatus. The battery pack has a first direction and a second direction intersecting each other, includes: a housing, having an accommodating cavity; multiple electrode assemblies, arranged along the first direction and provided in the accommodating cavity, where the electrode assembly includes a battery cell and a tab electrically connected, and the tabs of the electrode assemblies are arranged along the first direction; and an adapter circuit board, including a board body and multiple first pads spaced apart along the first direction, where the board body has multiple first channels penetrating the board body along the second direction; the first pad is provided on a side of the board body away from the battery cell along the second direction and connected thereto; the multiple first pads and first channels are alternately arranged along the first direction. At least two adjacent tabs are inserted into one first channel and electrically connected to one first pad. The present application helps simplify the structure of the battery pack, improve the integration level, and reduce the short circuit risk.

## Description

This application claims the priority of the Chinese Patent Application No. 202423303230.3 filed with the China National Intellectual Property Administration on December 30, 2024, entitled "Battery Pack and Electrical Apparatus", which is hereby incorporated by reference in its entirety.

### TECHNICAL FIELD

The present application belongs to the technical field of batteries, and in particular to a battery pack and an electrical apparatus.

### BACKGROUND

Due to its small overall envelope, a low-voltage battery pack requires a high degree of integration. However, components in the low-voltage battery pack are isolated, and busbars and flexible circuit boards are still assembled as independent electrical components in the entire battery pack, which affects the integration level of the low-voltage battery pack.

### SUMMARY

Purpose of the application: embodiments of the present application provide a battery pack, aiming to solve the problem that components in a low-voltage battery pack are isolated, and a busbar, a flexible circuit board and the like are still assembled as independent electrical components in the entire battery pack, which affects the integration level of the low-voltage battery pack. Another purpose of the embodiments of the present application is to provide an electrical apparatus.

Technical solution: a battery pack according to an embodiment of the present application has a first direction and a second direction intersecting each other, and includes:
a housing, having an accommodating cavity;
a plurality of electrode assemblies, arranged along the first direction, where the plurality of electrode assemblies are provided in the accommodating cavity, the electrode assembly includes a battery cell and a tab that are electrically connected, and the tabs of the plurality of electrode assemblies are arranged along the first direction; and
an adapter circuit board, including:
   a board body, provided on a side of the battery cell along the second direction, where the board body has a plurality of first channels spaced apart along the first direction, and the first channels penetrate through the board body along the second direction; and
   a plurality of first pads, spaced apart along the first direction, where the first pads are provided on a side of the board body away from the battery cell along the second direction and connected to the board body; the plurality of first pads and the plurality of first channels are alternately arranged along the first direction; and at least two of the tabs adjacent along the first direction are inserted into one of the first channels and are electrically connected to the first pad located on a side of the first channel.

In some embodiments, the battery pack has a third direction intersecting the first direction and the second direction, and the board body includes:
a first connecting part, configured to connect electrical components; and
a second connecting part, arranged side by side with the first connecting part along the third direction and integrally connected to the first connecting part; where the first pads are provided on a side of the second connecting part away from the battery cell along the second direction and connected to the second connecting part; the first channels penetrate through the second connecting part along the second direction and are spaced apart from the first pads; at least two of the tabs adjacent along the first direction are inserted into one of the first channels and connected to a side of one of the first pads adjacent to the first channel, and the side of one of the first pads adjacent to the first channel is away from the second connecting part.

In some embodiments, the first channels penetrate through a side of the second connecting part away from the first connecting part along the third direction.

In some embodiments, the first channel includes a first section and a second section, and the second section is provided on a side of the first section away from the first connecting part; and along the first direction, a dimension of the second section is larger than a dimension of the first section.

In some embodiments,
the board body further includes a third connecting part, the third connecting part is provided on a side of the first connecting part away from the second connecting part along the third direction and integrally connected to the first connecting part;
the board body has a plurality of second channels spaced apart along the first direction, and the second channels penetrate through the third connecting part along the second direction;
the adapter circuit board further includes a plurality of second pads spaced apart along the first direction, the plurality of second pads are provided on a side of the third connecting part along the second direction and connected to the board body; the plurality of second pads and the plurality of second channels are alternately arranged along the first direction; and
the electrode assembly includes two tabs, and the two tabs are spaced apart along the third direction; along the first direction, at least two of the adjacent tabs close to the third connecting part are inserted into one of the second channels and electrically connected to one of the second pads located on a side of the second channel, and at least two of the adjacent tabs close to the second connecting part are inserted into one of the first channels.

In some embodiments, the second channel includes a third section and a fourth section, the fourth section is provided on a side of the third section away from the first connecting part, and along the first direction, a dimension of the third section is larger than a dimension of the fourth section.

In some embodiments, the first channels and the second channels are arranged in a staggered manner along the third direction, and the first pads and the second pads are arranged in a staggered manner along the third direction.

In some embodiments, a side of the second connecting part away from the battery cell is provided with a plurality of first grooves spaced apart along the first direction, the plurality of first grooves and the plurality of first channels are alternately arranged and spaced apart along the first direction; each of the first pads is embedded in one of the first grooves; and
a side of the third connecting part away from the battery cell is provided with a plurality of second grooves spaced apart along the first direction, the plurality of second grooves and the plurality of second channels are alternately arranged and spaced apart along the first direction; each of the second pads is embedded in one of the second grooves.

In some embodiments, the first connecting part has at least one positioning hole, and the positioning hole penetrates through the first connecting part along the second direction.

Correspondingly, an electrical apparatus according to an embodiment of the present application includes the battery pack according to any one of the foregoing embodiments.

Beneficial effects: a battery pack according to an embodiment of the present application has a first direction and a second direction intersecting each other, and includes a housing, a plurality of electrode assemblies and an adapter circuit board. The housing has an accommodating cavity. The plurality of electrode assemblies are arranged along the first direction and provided in the accommodating cavity. The electrode assembly includes a battery cell and a tab that are electrically connected, and the tabs of the plurality of electrode assemblies are arranged along the first direction. The adapter circuit board includes a board body and a plurality of first pads spaced apart along the first direction. The board body has a plurality of first channels spaced apart along the first direction, and the first channels penetrate through the board body along the second direction. The plurality of first pads spaced apart along the first direction are provided on a side of the board body away from the battery cell along the second direction and connected to the board body. The plurality of first pads and the plurality of first channels are alternately arranged along the first direction. At least two of the tabs adjacent along the first direction are inserted into one of the first channels and are electrically connected to the first pad located on a side of the first channel. In the embodiments of the present application, by arranging the adapter circuit board, the tabs of the electrode assemblies are directly welded to the adapter circuit board to realize electrical connection. Compared with the traditional combination of structures such as busbars and electrical isolation brackets, the internal structure of the battery is effectively simplified, the internal integration level of the battery pack is effectively improved, and the volumetric energy density of the battery pack is favorably enhanced. In addition, in the adapter circuit board of the present application, a plurality of first pads and a plurality of first channels are alternately arranged on the board body, and at least two adjacent tabs are gathered into one first channel and connected to one first pad, which can realize connection of adjacent electrode assemblies and help reduce the short circuit risk of the electrode assemblies.

An electrical apparatus according to an embodiment of the present application includes the battery pack according to any one of the foregoing embodiments. It can be understood that the electrical apparatus of the embodiment of the present application includes all technical features and technical effects of the foregoing embodiments, which will not be repeated herein.

### BRIEF DESCRIPTION OF DRAWINGS

To more clearly illustrate the technical solutions in embodiments of the present application, the following briefly introduces the accompanying drawings required for describing the embodiments. Apparently, the accompanying drawings described below are only some embodiments of the present application, and those skilled in the art may obtain other drawings based on these accompanying drawings without creative efforts.
FIG. 1 is an overall schematic structural diagram of a battery pack according to an embodiment of the present application.
FIG. 2 is an exploded view of a battery pack according to an embodiment of the present application.
FIG. 3 is a schematic structural diagram of a connection between an electrode assembly and an adapter circuit board according to an embodiment of the present application.
FIG. 4 is a schematic structural diagram of an arrangement of electrode assemblies and gathering and bending of tabs according to an embodiment of the present application.
FIG. 5 is a top view of an adapter circuit board according to an embodiment of the present application.
FIG. 6 is a cross-sectional view taken along a section line A-A in FIG. 5.
FIG. 7 is a cross-sectional view taken along a section line B-B in FIG. 5.
FIG. 8 is a top view of a board body according to an embodiment of the present application.
FIG. 9 is a perspective view of an adapter circuit board according to an embodiment of the present application.

### Reference signs:

1. housing; 11. accommodating cavity; 2. electrode assembly; 21. battery cell; 22. tab; 3. adapter circuit board; 31. board body; 311. first channel; 3111. first section; 3112. second section; 312. first connecting part; 3121. positioning hole; 313. second connecting part; 3131. first groove; 314. third connecting part; 3141. second groove; 315. second channel; 3151. third section; 3152. fourth section; 33. first pad; 34. second pad; X. first direction; Z. second direction; Y. third direction.

### DESCRIPTION OF EMBODIMENTS

The technical solutions in embodiments of the present application are clearly and completely described below with reference to the accompanying drawings in the embodiments of the present application. Apparently, the described embodiments are merely part of the embodiments of the present application, rather than all of the embodiments. Based on the embodiments of the present application, all other embodiments obtained by those skilled in the art without creative labor shall fall within the protection scope of the present application.

In the description of the present application, it should be understood that orientations or positional relationships indicated by the terms such as "length", "width", "thickness", "upper", "lower", "front", "rear", "left", "right", "top", "bottom", "inner" and "outer" are based on the orientations or positional relationships shown in the accompanying drawings, which are only for convenience of describing the present application and simplifying the description, and do not indicate or imply that the referred device or element must have a specific orientation, be constructed and operated in a specific orientation. Therefore, they shall not be construed as limitations to the present application. In addition, the terms "first" and "second" are only used for descriptive purposes, and shall not be construed as indicating or implying relative importance or implicitly indicating the number of indicated technical features. Thus, features defined as "first" and "second" may explicitly or implicitly include one or more such features. In the description of the present application, the meaning of "a plurality" is two or more, and "at least one" may be one, two or more than two, unless otherwise clearly and specifically defined. In the description of the present application, "vertical" means completely perpendicular at 90° or nearly completely perpendicular. For example, an included angle within the range of 80° to 100° is regarded as vertical. Similarly, "parallel" means completely parallel or nearly completely parallel. For example, an angle within 10° of complete parallelism is regarded as parallel.

It should also be noted that in the accompanying drawings of the present application, an arrow marked with X indicates a first direction X, an arrow marked with Z indicates a second direction Z, and an arrow marked with Y indicates a third direction Y. The introduction of the first direction X, the second direction Z and the third direction Y is to facilitate the description of a structural positional relationship of a battery pack and further facilitate the understanding of the structure of the battery pack. In the embodiments of the present application, the first direction X is an arrangement direction of a plurality of electrode assemblies, the second direction X is a height direction of the battery pack, and the third direction Y is an arrangement direction of a first connecting part, a second connecting part and a third connecting part. The first direction X, the second direction Z and the third direction Y intersect each other. Further, the first direction X, the second direction Z and the third direction Y are mutually perpendicular.

A soft-pack battery has the advantages of light weight, small internal resistance, large capacity, good safety performance and the like, and has been widely applied. Due to the soft texture and small volume of the soft-pack battery, a busbar and a flexible circuit board for connecting tabs are still assembled as independent electrical components in the entire battery pack, resulting in low integration level of the soft-pack battery and low volumetric energy density of the entire battery pack.

In view of this, the embodiments of the present application provide a battery pack to solve the above problems.

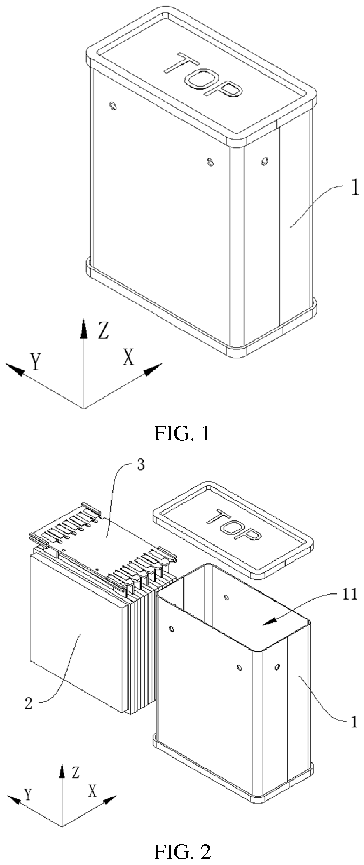

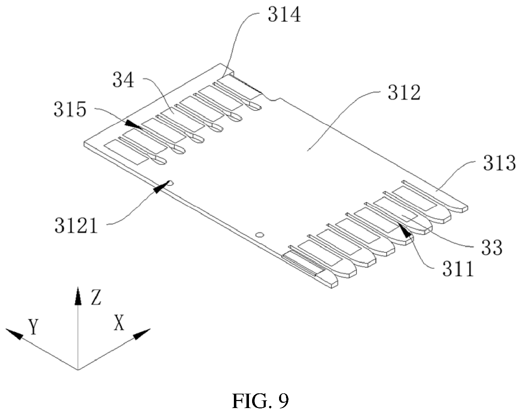

Referring to FIGS. 1-5 and FIG. 9, an embodiment of the present application provides a battery pack having a first direction X and a second direction Z intersecting each other, including a housing 1, a plurality of electrode assemblies 2 and an adapter circuit board 3. The housing 1 is provided with an accommodating cavity 11. The plurality of electrode assemblies 2 are arranged along the first direction X and provided in the accommodating cavity 11. The electrode assembly 2 includes a battery cell 21 and a tab 22 that are electrically connected, and the tabs 22 of the plurality of electrode assemblies 2 are arranged along the first direction X. The adapter circuit board 3 includes a board body 31 and a plurality of first pads 33 spaced apart along the first direction X. The board body 31 is provided on a side of the battery cell 21 along the second direction Z. The board body 31 is provided with a plurality of first channels 311 spaced apart along the first direction X, and the first channels 311 penetrate through the board body 31 along the second direction Z. The plurality of first pads 33 spaced apart along the first direction X are provided on a side of the board body 31 away from the battery cell 21 along the second direction Z and connected to the board body 31. The plurality of first pads 33 and the plurality of first channels 311 are alternately arranged along the first direction X. At least two of the tabs 22 adjacent along the first direction X are inserted into one of the first channels 311 and electrically connected to the first pad 33 located on a side of the first channel 311.

In the embodiment of the present application, by providing the adapter circuit board 3, the tabs 22 of the electrode assemblies 2 are directly welded to the adapter circuit board 3 to realize electrical connection. Compared with the combination of traditional structures such as busbars and electrical isolation brackets, the internal structure of the battery is effectively simplified, and the internal integration level of the battery is improved. In addition, in the adapter circuit board 3 of the present application, a plurality of first pads 33 and a plurality of first channels 311 are alternately arranged on the board body 31, such that at least two of the adjacent tabs 22 are gathered into one of the first channels 311 and connected to one of the first pads 33, which may realize connection of adjacent electrode assemblies 2 and help reduce the short circuit risk of the electrode assemblies 2.

Specifically, in the embodiment of the present application, the first pad 33 may be embedded in the board body 31, which helps prevent the first pad 33 from falling off and maintain the structural stability of the adapter circuit board 3. A voltage sampling line and the like may be arranged inside the board body 31, and the voltage sampling line may be electrically connected to the first pad 33. In this case, the voltage on the first pad 33 can be collected through the voltage sampling line. The board body 31 may be an epoxy resin board, which has good insulation performance and a certain hardness, so as to maintain structural stability and provide supporting performance for the first pad 33. The embodiment of the present application adopts the combination of the first pad 33 and the board body 31 to replace the existing solution of separately arranging and then combining electrical isolation plates, busbars and flexible circuit boards, which effectively improves the internal integration level of the battery pack and is conducive to increasing the volumetric energy density of the battery pack.

In addition, the first channel 311 is arranged between two adjacent first pads 33. In this case, the first channel 311 plays a role in isolating the two adjacent first pads 33, which increases a spacing between the two adjacent first pads 33, and helps avoid short circuit caused by contact with the adjacent first pad 33 when the tab 22 is connected to one of the first pads 33.

It should be noted that in the embodiment of the present application, at least two of the adjacent tabs 22 are gathered into one of the first channels 311 and electrically connected to the first pad 33, where the at least two of the adjacent tabs 22 may be understood as two tabs 22 or more than two tabs 22. The tabs 22 gathered into one of the first channels 311 may be specifically arranged according to the connection requirements of the plurality of electrode assemblies 2 inside the battery pack. For example, when two or more electrode assemblies 2 need to be connected in parallel, the tabs 22 of the two or more adjacent electrode assemblies 2 are gathered into one of the first channels 311, and the tabs 22 gathered into one of the first channels 311 have the same polarity, which may realize parallel connection of the two or more adjacent electrode assemblies 2. When two adjacent electrode assemblies 2 need to be connected in series, the tabs 22 of the two adjacent electrode assemblies 2 may be gathered into one of the first channels 311 and electrically connected to one of the first pads 33, where the polarities of the two tabs 22 are opposite.

It should also be noted that since the plurality of tabs 22 gathered in one of the first channels 311 are all connected to the same first pad 33, the plurality of tabs 22 may contact each other in the first channel 311 without causing problems such as short circuit or abnormal connection.

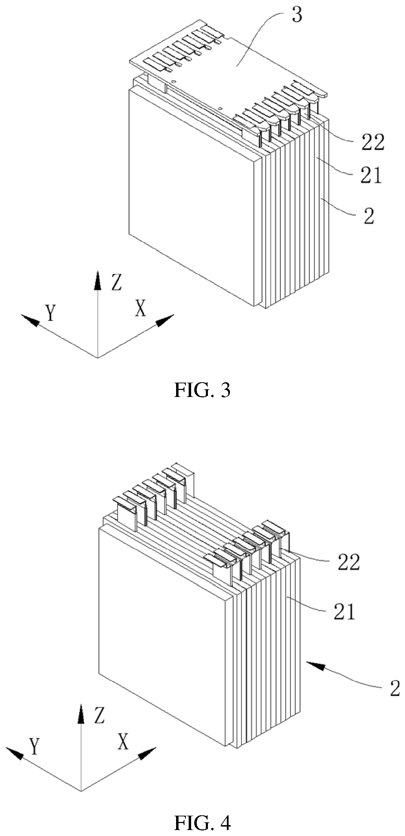

Referring to FIG. 3, FIG. 5, FIG. 8 and FIG. 9, in some embodiments, the battery pack has a third direction Y intersecting the first direction X and the second direction Z, and the board body 31 includes a first connecting part 312 and a second connecting part 313. The first connecting part 312 is configured to connect electrical components. The second connecting part 313 is arranged side by side with the first connecting part 312 along the third direction Y and integrally connected thereto. The first pads 33 are provided on a side of the second connecting part 313 away from the battery cell 21 along the second direction Z and connected to the second connecting part 313. The first channels 311 penetrate through the second connecting part 313 along the second direction Z and are spaced apart from the first pads 33. At least two tabs 22 adjacent along the first direction X are inserted into one of the first channels 311 and connected to a side of one of the first pads 33 adjacent to the first channel 311, the side of one of the first pads 33 adjacent to the first channel 311 is away from the second connecting part 313.

In the embodiment of the present application, the board body 31 is divided into the first connecting part 312 and the second connecting part 313. The first connecting part 312 is configured to arrange circuits such as the voltage sampling line inside, and the second connecting part 313 is configured to arrange connection positions of the first pads 33 and connected to the first pads 33. This zonal arrangement helps make full use of the internal space of the battery pack, and effectively reduce the dimension of the board body 31 along the second direction Z, thereby reducing the internal dimension of the battery pack occupied by the board along the second direction Z and helping effectively reduce the cost of the board body 31.

Referring to FIG. 3, FIG. 5, FIG. 8 and FIG. 9, in some embodiments, the first channel 311 penetrates through a side of the second connecting part 313 away from the first connecting part 312 along the third direction Y.

In an embodiment of the present application, the side of the first channel 311 away from the first connecting part 312 is open, which means the second connecting part 313 is comb-tooth shaped. In this case, the plurality of tabs 22 gathered together may directly be moved and insert into the first channel 311 along the third direction Y, which facilitates gathering the tabs 22 into the first channel 311 and reduces the difficulty of inserting the tabs 22 into the first channel 311.

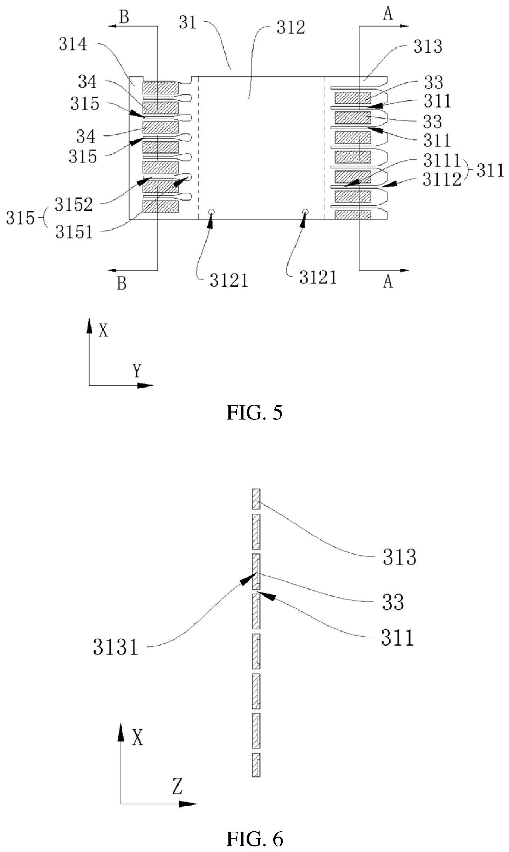

As shown in FIG. 5, in some embodiments, the first channel 311 includes a first section 3111 and a second section 3112. The second section 3112 is provided on a side of the first section 3111 away from the first connecting part 312. Along the first direction X, a dimension of the second section 3112 is larger than a dimension of the first section 3111.

In an embodiment of the present application, the dimension of the second section 3112 along the first direction X is larger than that of the first section 3111 along the first direction X, which makes it easier for a plurality of tabs 22 to enter the second section 3112 first, then enter the first section 3111 from the second section 3112 to realize the insertion and positioning of the tabs 22, and then be connected to a corresponding first pad 33.

Further, inner side walls of the first section 3111 and the second section 3112 are in smooth transition, and the dimension of the second section 3112 along the first direction X gradually increases in a direction away from the first section 3111, which further facilitates insertion of the tabs 22 from the second section 3112 into the first section 3111.

Referring to FIG. 3, FIG. 5, FIG. 8 and FIG. 9, in some embodiments, the board body 31 further includes a third connecting part 314. The third connecting part 314 is provided on a side of the first connecting part 312 away from the second connecting part 313 along the third direction Y and integrally connected to the first connecting part 312. The board body 31 has a plurality of second channels 315 spaced apart along the first direction X, and the second channels 315 penetrate through the third connecting part 314 along the second direction Z. The adapter circuit board 3 further includes a plurality of second pads 34 spaced apart along the first direction X. The plurality of second pads 34 are provided on a side of the third connecting part 314 along the second direction Z and connected to the board body 31. The plurality of second pads 34 and the plurality of second channels 315 are alternately arranged along the first direction X. The electrode assembly 2 includes two tabs 22, and the two tabs 22 are spaced apart along the third direction Y. At least two tabs 22 adjacent along the first direction X and close to the third connecting part 314 are inserted into one of the second channels 315 and electrically connected to the second pad 34 located on a side of the second channel 315.

In an embodiment of the present application, by arranging the third connecting part 314, the adapter circuit board 3 of the embodiment of the present application may be connected to both the positive and negative electrodes of the electrode assembly 2 at the same time. In this case, the corresponding positive and negative electrodes of the electrode assembly 2 are located on the same side of the battery cell 21, matched with the integrated adapter circuit board 3, it helps further simplify the internal structure of the battery pack, improves the integration level of the battery pack, and facilitates the improvement of the energy density of the battery pack. The second channel 315 is configured to gather adjacent tabs 22 that need to be connected to each other, which helps avoid the short circuit problem of the tabs 22.

Where the second pad 34 may be connected to a corresponding voltage sampling line in the first connecting part 312 to realize voltage signal collection at the second pad 34.

As shown in FIG. 5, in some embodiments, the second channel 315 includes a third section 3151 and a fourth section 3152. The fourth section 3152 is provided on a side of the third section 3151 away from the first connecting part 312. Along the first direction X, a dimension of the third section 3151 is larger than a dimension of the fourth section 3152.

In an embodiment of the present application, the second channel 315 is arranged to include the third section 3151 and the fourth section 3152, and the dimension of the third section 3151 is larger than that of the fourth section 3152. In this case, when the tabs 22 are inserted into the second channel 315, they may be inserted through the third section 3151 first, fully inserted into the second channel 315 gradually, and then move from the third section 3151 to the fourth section 3152 to gradually tighten the tabs 22, achieving the purpose of facilitating insertion and gathering of the tabs 22 as well as fixing.

It should be noted that different structural designs of the first channel 311 and the second channel 315 help reduce the difficulty of connecting the tabs 22 to the adapter circuit board 3. For example, initially, a plurality bundles of tab 22 connected to the second connecting part 313 may be respectively gathered first, then the adapter circuit board 3 is moved toward the tabs 22 along the third direction Y, and the plurality bundles of tab 22 pass through the second section 3112 and enter the first channel 311 respectively to realize insertion of the tabs 22 on one side. Then the tabs 22 on the other side are gathered into a bundle correspondingly, part of the tabs are inserted into the third section 3151 from the side of the third connecting part 314 facing the battery cell 21 first, and gradually gathered through the third section 3151, which is more conducive to the whole insertion of the bundle of tabs 22 into the second channel 315. The tabs 22 are then moved toward the fourth section 3152 for gathering, so that adjacent tabs 22 are stacked more closely to facilitate welding with the second pad 34.

It should be noted that in the embodiment of the present application, the pads may be uniformly arranged on the same side of the channels, which facilitates the tabs 22 to be uniformly bent toward one side and welded with the corresponding pads, helping save the assembly process of the battery pack.

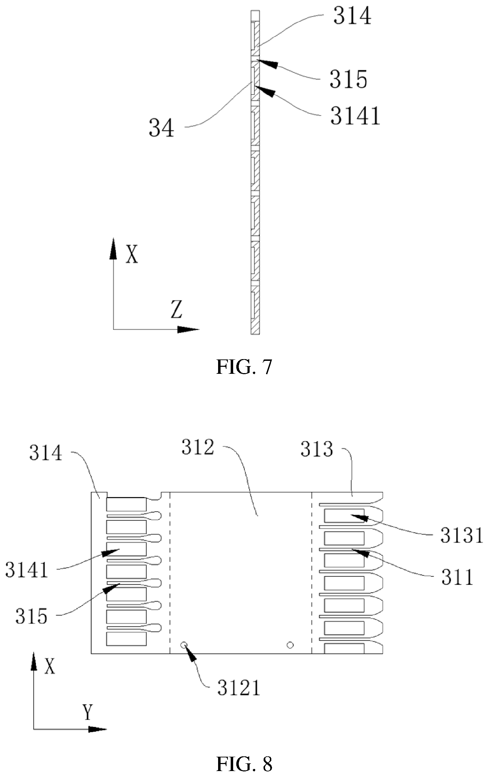

As shown in FIG. 5 and FIG. 8, in some embodiments, the first channel s 311 and the second channels 315 are arranged in a staggered manner along the third direction Y, and the first pads 33 and the second pads 34 are arranged in a staggered manner along the third direction Y.

In an embodiment of the present application, the plurality of electrode assemblies 2 may be arranged in series. In this case, the polarities of two adjacent tabs 22 along the first direction X are opposite, and the two adjacent tabs 22 are inserted into the same channel and welded with one corresponding pad to realize series connection of the two adjacent electrode assemblies 2. Therefore, by arranging the first channel 311 and the second channel 315 in a staggered manner and arranging the first pad 33 and the second pad 34 in a staggered manner in the embodiment of the present application, the first channel 311 and the second channel 315 adjacent along the third direction Y may realize series connection of three adjacent electrode assemblies 2 along the first direction X. For example, a negative tab 22 of a first electrode assembly 2 and a positive tab 22 of a second electrode assembly 2 are gathered into one of the second channels 315 and welded and connected to one corresponding second pad 34; the negative tab 22 of the second electrode assembly 2 and a positive tab 22 of a third electrode assembly 2 are gathered into one of the first channels 311 and welded and connected to one corresponding first pad 33, so as to realize series connection of three adjacent electrode assemblies 2.

As shown in FIG. 6, FIG. 7 and FIG. 8, in some embodiments, a side of the second connecting part 313 away from the battery cell 21 is provided with a plurality of first grooves 3131 spaced apart along the first direction X. The plurality of first grooves 3131 and the plurality of first channels 311 are alternately arranged and spaced apart along the first direction X. Each of the first pads 33 is embedded in one of the first grooves 3131. A side of the third connecting part 314 away from the battery cell 21 is provided with a plurality of second grooves 3141 spaced apart along the first direction X. The plurality of second grooves 3141 and the plurality of second channels 315 are alternately arranged and spaced apart along the first direction X. Each of the second pads 34 is embedded in one of the second grooves 3141.

In the embodiment of the present application, the first groove 3131 is arranged to accommodate the first pad 33, and the first pad 33 is embedded and installed in the first groove 3131 to realize effective fixed connection between the first pad 33 and the second connecting part 313. The second groove 3141 is arranged to accommodate the second pad 34, and the second pad 34 is embedded and installed in the second groove 3141 to realize effective fixed connection between the second pad 34 and the third connecting part 314. In this case, the grooves accommodate the dimension of the pads along the second direction Z, which not only helps ensure effective fixing of the pads, but also helps reduce the overall dimension of the adapter circuit board 3 along the second direction Z.

As shown in FIG. 5, FIG. 8 and FIG. 9, in some embodiments, the first connecting part 312 has at least one positioning hole 3121, and the positioning hole 3121 penetrates through the first connecting part 312 along the second direction Z.

In an embodiment of the present application, the arrangement of the positioning hole 3121 is configured to achieve positioning and fool-proofing effects during the installation of the adapter circuit board 3.

Correspondingly, an embodiment of the present application further provides an electrical apparatus, including the battery pack according to any one of the foregoing embodiments.

It may be understood that the electrical apparatus of the embodiment of the present application includes all technical features and technical effects of the foregoing embodiments, which would not be repeated herein.

Certainly, the electrical apparatus referred to in the present application may be application devices such as vehicles, mobile phones, portable equipment, notebook computers, ships, aerospace vehicles, electric toys and electric tools. The vehicle may be a new energy vehicle, and the new energy vehicle may be a pure electric vehicle, a hybrid electric vehicle or an extended-range electric vehicle; the aerospace vehicle includes aircraft, rockets, space shuttles, spacecraft and the like; the electric toys include fixed or mobile electric toys, such as game consoles, electric vehicle toys, electric ship toys, electric aircraft toys and the like; the electric tools include metal cutting electric tools, grinding electric tools, assembly electric tools and railway electric tools, such as electric drills, electric grinders, electric wrenches, electric screwdrivers, electric hammers, impact drills, concrete vibrators and electric planers. The embodiments of the present application are not specially limited to the above electrical apparatuses.

In the above embodiments, the description of each embodiment has its own emphasis, and parts not described in detail in a certain embodiment may refer to the relevant descriptions of other embodiments.

The battery pack and the electrical apparatus provided by the embodiments of the present application are described in detail above, and the principles and implementations of the present application are illustrated with specific examples. The description of the above embodiments is only used to help understand the technical solutions and their core ideas of the present application. Those of ordinary skill in the art should understand that they may still modify the technical solutions recorded in the foregoing embodiments or make equivalent replacements for part of the technical features thereof; such modifications or replacements shall not make the essence of the corresponding technical solutions depart from the scope of the technical solutions of the embodiments of the present application.

## Claims

1. A battery pack, having a first direction and a second direction intersecting each other, comprising:
a housing, having an accommodating cavity;
a plurality of electrode assemblies, arranged along the first direction, wherein the plurality of electrode assemblies are provided in the accommodating cavity, the electrode assembly comprises a battery cell and a tab that are electrically connected, and the tabs of the plurality of electrode assemblies are arranged along the first direction; and
an adapter circuit board, comprising:
a board body, provided on a side of the battery cell along the second direction, wherein the board body has a plurality of first channels spaced apart along the first direction, and the first channels penetrate through the board body along the second direction; and
a plurality of first pads, spaced apart along the first direction, wherein the first pads are provided on a side of the board body away from the battery cell along the second direction and connected to the board body; the plurality of first pads and the plurality of first channels are alternately arranged along the first direction; and at least two of the tabs adjacent along the first direction are inserted into one of the first channels and are electrically connected to the first pad located on a side of the first channel.

2. The battery pack according to claim 1, wherein the battery pack has a third direction intersecting the first direction and the second direction, and the board body comprises:
a first connecting part, configured to connect electrical components; and
a second connecting part, arranged side by side with the first connecting part along the third direction and integrally connected to the first connecting part; wherein the first pads are provided on a side of the second connecting part away from the battery cell along the second direction and connected to the second connecting part; the first channels penetrate through the second connecting part along the second direction and are spaced apart from the first pads; and at least two of the tabs adjacent along the first direction are inserted into one of the first channels and connected to a side of one of the first pads adjacent to the first channel, and the side of one of the first pads adjacent to the first channel is away from the second connecting part.

3. The battery pack according to claim 2, wherein the first channels penetrate through a side of the second connecting part away from the first connecting part along the third direction.

4. The battery pack according to claim 3, wherein the first channel comprises a first section and a second section, and the second section is provided on a side of the first section away from the first connecting part; and along the first direction, a dimension of the second section is larger than a dimension of the first section.

5. The battery pack according to claim 4, wherein inner side walls of the first section and the second section are in smooth transition, and the dimension of the second section along the first direction gradually increases in a direction away from the first section.

6. The battery pack according to claim 2, wherein,
the board body further comprises a third connecting part, the third connecting part is provided on a side of the first connecting part away from the second connecting part along the third direction and integrally connected to the first connecting part;
the board body has a plurality of second channels spaced apart along the first direction, and the second channels penetrate through the third connecting part along the second direction;
the adapter circuit board further comprises a plurality of second pads spaced apart along the first direction, the plurality of second pads are provided on a side of the third connecting part along the second direction and connected to the board body; and the plurality of second pads and the plurality of second channels are alternately arranged along the first direction; and
the electrode assembly comprises two tabs, and the two tabs are spaced apart along the third direction; along the first direction, at least two of the adjacent tabs close to the third connecting part are inserted into one of the second channels and electrically connected to one of the second pads located on a side of the second channel, and at least two of the adjacent tabs close to the second connecting part are inserted into one of the first channels.

7. The battery pack according to claim 6, wherein the second channel comprises a third section and a fourth section, the fourth section is provided on a side of the third section away from the first connecting part, and along the first direction, a dimension of the third section is larger than a dimension of the fourth section.

8. The battery pack according to claim 6, wherein the first channels and the second channels are arranged in a staggered manner along the third direction, and the first pads and the second pads are arranged in a staggered manner along the third direction.

9. The battery pack according to claim 6, wherein,
a side of the second connecting part away from the battery cell is provided with a plurality of first grooves spaced apart along the first direction, the plurality of first grooves and the plurality of first channels are alternately arranged and spaced apart along the first direction; each of the first pads is embedded in one of the first grooves; and
a side of the third connecting part away from the battery cell is provided with a plurality of second grooves spaced apart along the first direction, the plurality of second grooves and the plurality of second channels are alternately arranged and spaced apart along the first direction; each of the second pads is embedded in one of the second grooves.

10. The battery pack according to claim 2, wherein the first connecting part has at least one positioning hole, and the positioning hole penetrates through the first connecting part along the second direction.

11. The battery pack according to claim 1, wherein the board body is provided with a plurality of first grooves spaced apart along the first direction, the plurality of first grooves and the plurality of first channels are alternately arranged along the first direction; and the first pad is embedded in a corresponding one of the first grooves.

12. The battery pack according to claim 1, wherein a voltage sampling line is arranged in the board body, and is electrically connected to the first pad.

13. The battery pack according to claim 1, wherein the board body is an epoxy resin board.

14. The battery pack according to claim 1, wherein polarities of the plurality of tabs inserted into the same first channel are the same to realize parallel connection of the plurality of electrode assemblies; or polarities of two tabs inserted into the same first channel are opposite to realize series connection of the two electrode assemblies.

15. An electrical apparatus, comprising the battery pack according to any one of claims 1 to 14.
